# EUROPÄISCHE PATENTSCHRIFT

(11) **EP 3 171 682 B1**
(45) Veröffentlichungstag und Bekanntmachung des Hinweises auf die Patenterteilung: **23.09.2020**
(21) Anmeldenummer: 16200128.3
(22) Anmeldetag: 23.11.2016
(51) Int. Cl.: H05K 7/14, H02B 1/00

(54) **VERTEILUNGSSYSTEM MIT EINER ELEKTRONISCHEN SICHERUNGSKLEMME UND ZUMINDEST EINER ERSTEN REIHENKLEMME**
DISTRIBUTION SYSTEM HAVING AN ELECTRONIC FUSE TERMINAL AND AT LEAST ONE FIRST TERMINAL BLOCK
SYSTÈME DE DISTRIBUTION COMPRENANT UNE DOUILLE DE FUSIBLE ÉLECTRONIQUE ET AU MOINS UNE BARRETTE DE RACCORDEMENT

(30) Priorität: 23.11.2015 DE 202015106368 U
(43) Veröffentlichungstag der Anmeldung: 24.05.2017
(73) Patentinhaber: PHOENIX CONTACT GmbH & Co. KG, 32825 Blomberg (DE)
(72) Erfinder: Berg, Peter, 33189 Schlangen (DE); Fomenko, Alexander, 33605 Bielefeld (DE); Wetter, Martin, 32760 Detmold (DE); Nahles, Guido, 33175 Bad Lippspringe (DE); Jürgenhake Christian, 33397 Rietberg (DE); Ketler Peter, 32758 Detmold (DE); Plattmann Carsten, 33106 Paderborn (DE); Bessler Timo, 32825 Blomberg (DE)
(74) Vertreter: RCD Patent Giesen, Schmelcher & Griebel Patentwanwälte PartG mbB

(56) Entgegenhaltungen:
- WO-A1-2015/124800
- DE-A1-102004 013 477

## Beschreibung

### Phoenix Contact GmbH & Co KG, Blomberg

Die Erfindung betrifft ein Verteilungssystem mit einer elektronischen Sicherungsklemme und zumindest einer ersten Reihenklemme.

Aus dem Stand der Technik sind bereits elektronische Sicherungen wie beispielsweise aus DE 10 2004 013477 A1 bekannt.

Für Tragschienenmontage sind unterschiedliche Systeme wie beispielsweise aus WO 2015/124800 A1 bekannt.

Zum einen gibt es sogenannte 1-kanalige Lösungen, die ein Potential gesichert an einem Anschluss zur Verfügung stellen, zum anderen gibt es mehrkanalige Lösungen, die mehrere Potentiale gesichert an unterschiedlichen Anschlüssen zur Verfügung stellen.

Allerdings sind diese Lösungen nicht geeignet in einem industriellen Umfeld für eine Mehrzahl von Verbrauchern ein gesichertes Potential oder mehrere gesicherte Potentiale raumsparend und kostengünstig im Aufbau zur Verfügung zu stellen.

Der Erfindung liegt die Aufgabe zu Grunde, eine verbessertes und kostengünstiges Verteilungssystem mit einer elektronischen Sicherungsklemme zu schaffen, die einen oder mehrere Nachteile aus dem Stand der Technik vermeidet.

Die Lösung der Aufgabe erfolgt erfindungsgemäß durch die Merkmale des unabhängigen Anspruchs. Vorteilhafte Ausgestaltungen der Erfindung sind in den Unteransprüchen angegeben.

Nachfolgend wird die Erfindung unter Bezugnahme auf die anliegende Zeichnung anhand bevorzugter Ausführungsformen näher erläutert.

Es zeigen
- Fig. 1: eine erste Prinzip-Darstellung gemäß Ausführungsformen der Erfindung,
- Fig. 2: eine zweite Prinzip-Darstellung gemäß Ausführungsformen der Erfindung. und
- Fig. 3: eine dritte Prinzip-Darstellung gemäß Ausführungsformen der Erfindung.

Nachfolgend wird die Erfindung eingehender unter Bezugnahme auf die Figur dargestellt werden. Dabei ist anzumerken, dass unterschiedliche Aspekte beschrieben werden, die jeweils einzeln oder in Kombination zum Einsatz kommen können. D.h. jeglicher Aspekt kann mit unterschiedlichen Ausführungsformen der Erfindung verwendet werden, soweit nicht explizit als reine Alternative dargestellt.

Weiterhin wird nachfolgend der Einfachheit halber in aller Regel immer nur auf eine Entität Bezug genommen werden. Soweit nicht explizit vermerkt, kann die Erfindung aber auch jeweils mehrere der betroffenen Entitäten aufweisen. Insofern ist die Verwendung der Wörter "ein", "eine" und "eines" nur als Hinweis darauf zu verstehen, dass in einer einfachen Ausführungsform zumindest eine Entität verwendet wird.

In der nachfolgenden Beschreibung wird Bezug auf die Abbildungen genommen. Dabei werden in aller Regel gleiche oder gleichartige Elemente mit gleichen oder gleichartigen Referenzzeichen bezeichnet werden.

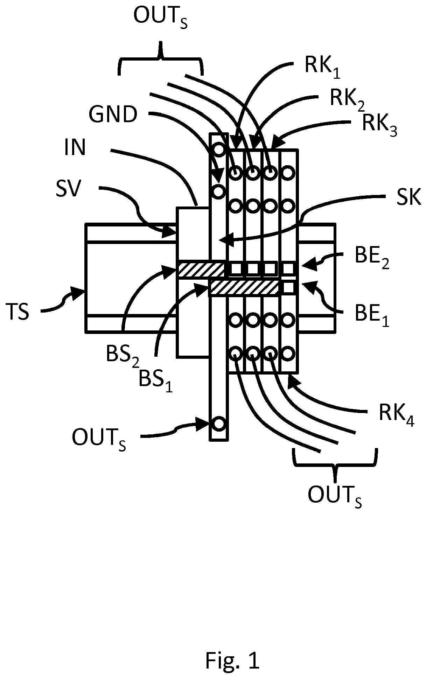

Ein beispielhaftes Verteilungssystem gemäß der Erfindung ist in Abbildung 1 dargestellt.

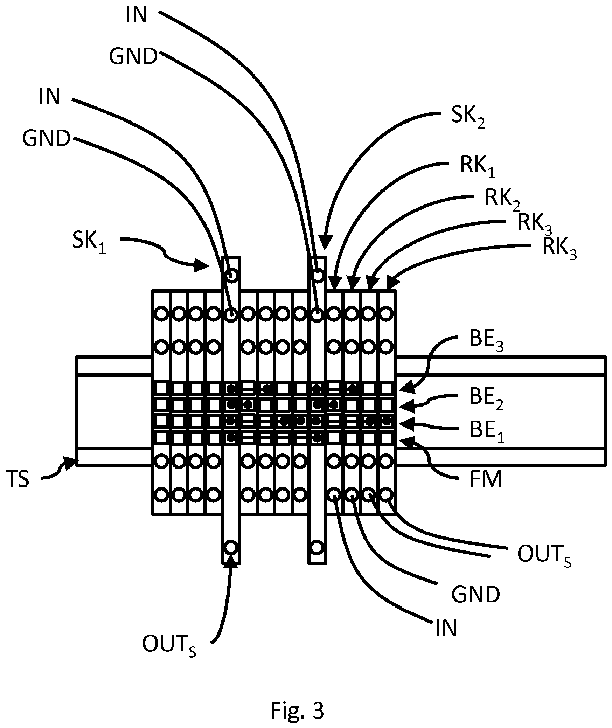

Das Verteilungssystem weist mindestens eine elektronische Sicherungsklemme SK₁ auf. Dabei ist die Erfindung aber nicht hierauf beschränkt, sondern kann - wie z.B. aus der Abbildung 3 ersichtlich ist - auch mit 2 oder mehr elektronischen Sicherungsklemmen SK₂ verwendet werden.

Weiterhin weist das beispielhafte Verteilungssystem gemäß der Erfindung zumindest eine erste Reihenklemme RK₁ auf.

Reihenklemmen sind dabei dazu vorgesehen Potentiale an eine Mehrzahl von Abnehmern zur Verfügung zu stellen. Reihenklemmen weisen dazu nebeneinanderliegende Brückungsschächte (in Brückungsebenen) auf, welche z.B. der Verteilung von Potentialen zwischen den Reihenklemmen dienen. Manche Reihenklemmen weisen auch ein oder mehrere Anschlüsse in einer oder mehreren Ebenen auf, an denen das jeweilige über die Brückung zur Verfügung gestellte Potential zu den Abnehmern geführt werden kann.

Die elektronische Sicherungsklemme SK₁ und die zumindest eine Reihenklemme RK₁ sind unmittelbar benachbart auf einer Montageschiene TS angeordnet. Die Montageschiene kann dabei eine Profilschiene, beispielsweise eine Hutschiene oder eine G-Schiene, aus einem geeigneten Material sein. Ein Beispiel einer solchen Montageschiene TS ist die sogenannte DIN-Schiene.

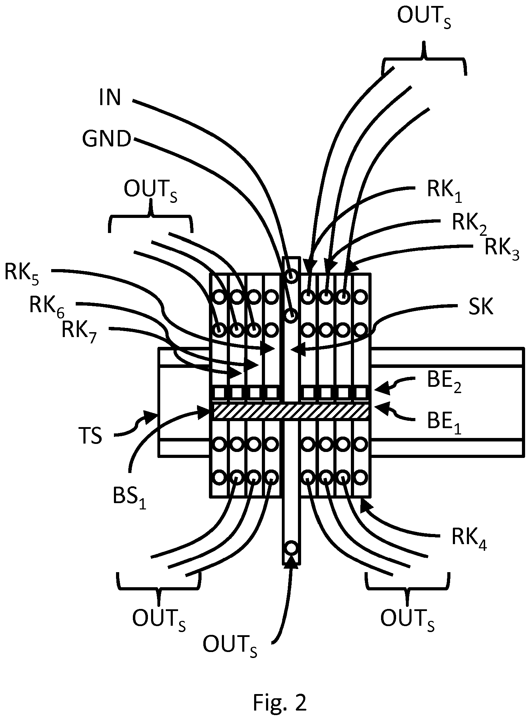

Die elektronische Sicherungsklemme SK₁ und die zumindest eine erste Reihenklemme RK₁ verfügen über zumindest je einen benachbarten Brückungsschacht. In der Abbildung 1 und 2 ist ein Beispiel mit zwei Brückungsschächten gezeigt, wobei die Brückungsschächte in Brückungsebenen BE₁ und BE₂ angeordnet sind. In der Abbildung 3 ist ein Beispiel mit vier Brückungsschächten in den Brückungsebenen BE₁ bis BE₄ gezeigt.

In der Abbildung 1 wird die elektronische Sicherungsklemme SK₁ mittelbar über eine Stromanschlussklemme SV, welche ebenfalls auf der Montageschiene TS angeordnet ist, über einen zweiten Brückungsstecker BS₂ mit einer Eingangsspannung IN versorgt.

In Abbildung 2 und 3 wird hingegen die Eingangsspannung IN direkt an die elektronische Sicherungsklemme SK₁ angeschlossen. D.h. das vorgestellte erfindungsgemäße System ist äußerst flexibel und erlaubt z.B. über die Stromanschlussklemme SV den Anschluss leistungsfähiger Energiequellen. Beispielsweise kann der Anschluss der Stromanschlussklemme SV einen größeren Leiter-Querschnitt als die elektronische Sicherungsklemme SK₁ bieten.

Soweit im Folgenden Potentiale aufgezeigt werden, die eine Verwendung von Gleichspannung nahelegen, sei darauf hingewiesen, dass die Erfindung nicht hierauf beschränkt ist.

Die elektronische Sicherungsklemme SK₁ stellt zumindest ein erstes Ausgangspotential OUT_{S} gesichert zur Verfügung.

Dabei wird das gesicherte erste Ausgangspotential OUT_{S} mittels eines ersten Brückungssteckers BS₁ an die erste Reihenklemme RK₁ weitergereicht.

Gemäß einem Aspekt der Erfindung ist es zudem möglich, dass das System weiterhin an einem zweiten Brückungsschacht ein zweites Ausgangspotential GND, IN zur Verfügung stellt, das verschieden vom ersten Ausgangspotential OUT_{S} ist. Beispielsweise ist in Abbildung 3 gezeigt, dass die elektronische Sicherungsklemme SK₂ an die Reihenklemme RK₁ das (ungesicherte) Eingangspotential in der Brückungsebene BE2 weiterreicht, während in der Brückungsebene BE3 ein Erdpotential GND an die Reihenklemme RK2 und das gesicherte Ausgangspotential OUTs in der Brückungsebene BE1 weitergereicht wird. D.h. mit einer entsprechenden Ausgestaltung der Brückungsschächte können unterschiedliche Potentiale - sowohl gesicherte als auch ungesicherte - verteilt werden.

Zwar kann das Erdpotential GND, wie in den Abbildungen dargestellt, mittels eines Anschlusses der elektronischen Sicherungsklemme zugeführt sein, es wäre alternativ oder zusätzlich möglich ein Erdpotential auch mittels einer metallischen Montageschiene TS zur Verfügung zu stellen, wobei dann beim Aufbringen der elektronischen Sicherungsklemme ein elektrischer Kontakt mit der Montageschiene hergestellt wird, z.B. mittels metallischer Befestigungselemente.

Natürlich kann das System weiterhin zumindest eine zweite Reihenklemme aufweisen, wobei die zweite Reihenklemme ebenfalls über zumindest einen benachbarten Brückungsschacht verfügt, und wobei die elektronische Sicherungsklemme SK₁ und die zweite Reihenklemme unmittelbar benachbart auf der Montageschiene TS angeordnet sind.

Dabei kann, wie in Abbildung 2 gezeigt, das gesicherte erste Ausgangspotential OUT_{S} an die zweite Reihenklemme RK₅ mittels des ersten Brückungssteckers BS₁ und/oder eines zweiten Brückungssteckers (nicht dargestellt) an die zweite Reihenklemme RK₅ weitergereicht werden.

Beispielsweise kann es erforderlich sein, mittels mehrerer Brückungsstecker parallele Verbindungen aufzubauen, um so z.B. einen gewissen Strom tragen zu können.

D.h. in Abbildung 2 wird das gesicherte Ausganspotential OUT_{S} sowohl an die Reihenklemmen RK_{5..7} links der elektronische Sicherungsklemme SK₁ als auch an die Reihenklemmen RK_{1..4} rechts der elektronische Sicherungsklemme SK₁ verteilt.

Andererseits ist es aber auch möglich, unterschiedliche (gesicherte und/oder ungesicherte) Potentiale nach rechts und nach links zu verteilen, wie aus einer Zusammenschau der Lehren der Abbildung 2 und der Abbildung 3 unmittelbar einsichtig wird.

Besonders vorteilhaft kann zudem vorgesehen sein, dass die elektronische Sicherungsklemme SK₁ eine Fernmeldung FM zur Verfügung stellt. Diese Fernmeldung kann zugleich aber auch z.B. als Summenfernmeldung, wie in Abbildung 3 gezeigt, verwendet werden. Hiermit kann z.B. in größeren Schaltungen eine Fernmeldung an einen Servicetechniker bereitgestellt werden, sodass die betroffene Schaltung schneller auffindbar ist.

Alternativ oder zusätzlich kann zudem eine akustische und/oder optische Warneinrichtung zur lokalen Fehlermeldung zur Verfügung gestellt sein, beispielsweise eine (rote) Leuchtdiode oder einen akustischen Signalgeber, um eine schnelle Auffindung einer fehlerbehafteten oder überlasteten elektronischen Sicherungsklemme zur Verfügung zu stellen. Alternativ oder zusätzlich kann auch eine (zusätzliche) Betriebsanzeige, z.B. mittels einer grünen LED, ermöglicht werden.

Von besonderem Vorteil ist, dass die elektronische Sicherungsklemme SK₁ eine Breite von weniger als 7 mm, insbesondere 6,2 mm aufweist und so in bevorzugte Rastermasse von Reihenklemmsystemen der Anmelderin eingefügt werden kann.

Weiterhin vorteilhaft kann bei der elektronischen Sicherungsklemme SK₁ ein auslösender Stromwert fest voreingestellte sein. Dieser Stromwert kann aber auch in der Produktion und/oder beim Einbau wählbar sein. Hierdurch kann auf individuelle Belange besser eingegangen werden und zugleich Kosten reduziert werden, da nunmehr der Stromwert passend für jedes Gerät bzw. jede Situation eingestellt werden kann.

Insbesondere kann vorgesehen sein, dass der maximale Strom des gesicherten Ausgangspotentials (OUT_{S}) auf einen voreingestellten Wert begrenzt (z.B. 6 A) oder aber bei Erreichen oder Überschreiten eines bestimmten Wertes unmittelbar oder mit Verzögerung abgeschaltet wird.

Zudem kann vorgesehen sein, dass die elektronische Sicherungsklemme SK₁ eine manuelle Auslösung der Sicherungsfunktion aufweist. Dies kann z.B. zum Schutz bei Montage- oder Wartungsarbeiten vorteilhaft sein.

D.h. mit der Erfindung ist es nunmehr möglich, eine größere Anzahl von Verbrauchern anzuschließen.

Zudem ist es mit der Erfindung möglich, eine größere Anzahl von Verbrauchern bauraumsparend anzuschließen.

**Bezugszeichenliste**

| | |
|---|---|
| Reihenklemme | RK_{1..N} |
| elektronische Sicherungsklemme | SK₁, SK₂ |
| Montageschiene | TS |
| Eingangsspannung | IN |
| erstes Ausgangspotential | OUT_{S} |
| Brückungsstecker | BS₁, BS₂ |
| Fernmeldung | FM |
| Stromanschlussklemme | SV |
| Brückungsebene | BE_{1..4} |

## Patentansprüche

1. Verteilungssystem mit einer elektronischen Sicherungsklemme (SK₁) und zumindest einer ersten Reihenklemme (RK₁),
• wobei die elektronische Sicherungsklemme (SK₁) und die zumindest eine erste Reihenklemme (RK₁) unmittelbar benachbart auf einer Montageschiene (TS) angeordnet sind, und wobei die elektronische Sicherungsklemme (SK₁) und die zumindest eine erste Reihenklemme (RK₁) über zumindest je zwei benachbarte Brückungsschächte verfügen,
• wobei die elektronische Sicherungsklemme (SK₁) mit ungesicherter Eingangsspannung (IN) versorgbar ist, wobei die elektronische Sicherungsklemme (SK₁) zumindest ein erstes Ausgangspotential (OUT_{S}) gesichert zur Verfügung stellt,
• **dadurch gekennzeichnet, dass** das gesicherte erste Ausgangspotential (OUT_{S}) an die erste Reihenklemme (RK₁) mittels eines ersten Brückungssteckers (BS₁) an die erste Reihenklemme (RK₁) in einer ersten Brückungsebene weitergereicht wird, wobei
das System weiterhin an einem zweiten Brückungsschacht in einer zweiten Brückungsebene ein zweites gesichertes Ausgangspotential (GND, IN) zur Verfügung stellt, das verschieden vom ersten Ausgangspotential (OUT_{S}) ist, wobei die ungesicherte Eingangsspannung (IN) direkt an eine zweite elektronische Sicherungsklemme (SK₂) angeschlossen werden kann.

2. Verteilungssystem nach Anspruch 1, **dadurch gekennzeichnet, dass** das System weiterhin zumindest eine zweite Reihenklemme (RK₂) aufweist, wobei die zweite Reihenklemme (RK₂) über zumindest einen benachbarten Brückungsschacht verfügt, wobei die elektronische Sicherungsklemme (SK₁) und die zweite Reihenklemme (RK₂) unmittelbar benachbart auf der Montageschiene (TS) angeordnet sind, wobei das gesicherte erste Ausgangspotential (OUT_{S}) an die zweite Reihenklemme (RK₂) mittels des ersten Brückungssteckers (BS₁) oder eines zweiten Brückungssteckers (BS₂) an die zweite Reihenklemme (RK₂) weitergereicht wird.

3. Verteilungssystem nach Anspruch 1, **dadurch gekennzeichnet, dass** das System weiterhin zumindest eine zweite Reihenklemme aufweist, wobei die elektronische Sicherungsklemme (SK₁) und die zweite Reihenklemme unmittelbar benachbart auf der Montageschiene (TS) angeordnet sind, wobei die zweite elektronische Sicherungsklemme (SK₂) zumindest das zweite Ausgangspotential gesichert zur Verfügung stellt, wobei das gesicherte zweite Ausgangspotential an die zweite Brückenklemme (SK₁) mittels eines zweiten Brückungssteckers (BS₂) an die zweite Reihenklemme weitergereicht wird.

4. Verteilungssystem nach einem der vorhergehenden Ansprüche, **dadurch gekennzeichnet, dass** die elektronische Sicherungsklemme (SK₁) eine Fernmeldung (FM) zur Verfügung stellt.

5. Verteilungssystem nach einem der vorhergehenden Ansprüche, **dadurch gekennzeichnet, dass** die elektronische Sicherungsklemme (SK₁) eine Warneinrichtung zur lokalen Fehlermeldung zur Verfügung stellt.

6. Verteilungssystem nach einem der vorhergehenden Ansprüche, **dadurch gekennzeichnet, dass** die elektronische Sicherungsklemme (SK₁) eine Breite von weniger als 7 mm, insbesondere 6,2 mm aufweist.

7. Verteilungssystem nach einem der vorhergehenden Ansprüche, **dadurch gekennzeichnet, dass** die elektronische Sicherungsklemme (SK₁) fest voreingestellten Stromwert aufweist.

8. Verteilungssystem nach einem der vorhergehenden Ansprüche, **dadurch gekennzeichnet, dass** die elektronische Sicherungsklemme (SK₁) den Strom des gesicherten Ausgangspotentials (OUT_{S}) auf einen voreingestellten Wert begrenzt.

9. Verteilungssystem nach einem der vorhergehenden Ansprüche, **dadurch gekennzeichnet, dass** die elektronischen Sicherungsklemme (SK₁) eine manuelle Auslösung der Sicherungsfunktion aufweist.

## Claims

1. A distribution system with an electronic fuse terminal (SK₁) and at least one first series terminal (RK₁),
• wherein the electronic fuse terminal (SK₁) and the at least one first series terminal (RK₁) are arranged immediately adjacent to one another on a mounting rail (TS), and wherein the electronic fuse terminal (SK₁) and the at least one first series terminal (RK₁) each have at least one adjacent bridging slot,
• wherein the electronic fuse terminal (SK₁) can be supplied with unprotected input voltage (IN), with the electronic fuse terminal (SK₁) making at least one protected first output potential (OUTs) available,
• **characterized in that** the protected first output potential (OUTs) is forwarded to the first series terminal (RK₁) by means of a first bridging plug (BS₁) to the first series terminal (RK₁) within a first bridging plane,
• whereby the system further at a second bridging slot within a second bridging plane also makes a second protected output potential (GND, IN) available, that is different from the first output potential (OUTs),
• whereby the unprotected input voltage (IN) may be directly connected towards a second electronic fuse terminal (SK₁).

2. The distribution system as set forth in claim, **characterized in that** the system further comprises at least one second series terminal (RK₂), wherein the second series terminal (RK₂) comprises at least one adjacent bridging slot, wherein the electronic fuse terminal (SK₁) and the second series terminal (RK₂) are arranged immediately adjacent to one another on the mounting rail (TS), and wherein the protected first output potential (OUT_{S}) is forwarded by means of the first bridging plug (BS₁) to the second series terminal (RK₂) or by means of a second bridging plug (BS₂) to the second series terminal (RK₂).

3. The distribution system as set forth in claim 1, **characterized in that** the system further comprises at least one second series terminal, wherein the electronic fuse terminal (SK₁) and the second series terminal are arranged immediately adjacent to one another on the mounting rail (TS), wherein the second electronic fuse terminal (SK₂) makes at least the second protected output potential protected available, and wherein the protected second output potential is forward by means of a second bridging plug (BS₂) to the second bridging terminal (SK₁) to the second series terminal.

4. The distribution system as set forth in any one of the preceding claims, **characterized in that** the electronic fuse terminal (SK₁) makes a remote signal (FM) available.

5. The distribution system as set forth in any one of the preceding claims, **characterized in that** the electronic fuse terminal (SK₁) makes an alarm device for local fault reporting available.

6. The distribution system as set forth in any one of the preceding claims, **characterized in that** the electronic fuse terminal (SK₁) has a width of less than 7 mm, particularly 6.2 mm.

7. The distribution system as set forth in any one of the preceding claims, **characterized in that** the electronic fuse terminal (SK₁) has a permanently preset current value.

8. The distribution system as set forth in any one of the preceding claims, **characterized in that** the electronic fuse terminal (SK₁) limits the current of the protected output potential (OUT_{S}) to a preset value.

9. The distribution system as set forth in any one of the preceding claims, **characterized in that** the electronic fuse terminal (SK₁) has a manual trigger for the fuse function.

## Revendications

1. Système de distribution comportant un porte-fusible électronique (SK₁), et au moins une première barrette à bornes (RK₁), dans lequel
• le porte-fusible électronique (SK₁) et l'au moins une première barrette à bornes (RK₁) sont disposés directement à proximité sur un rail de montage (TS), et le porte-fusible électronique (SK₁) et l'au moins une première barrette à bornes (RK₁) disposent chacun d'au moins deux colonnes de pontage voisines,
• le porte-fusible électronique (SK₁) peut être alimenté avec une tension d'entrée sans fusible (IN), le porte-fusible électronique (SK₁) mettant à disposition au moins un premier potentiel de sortie (OUTs) avec fusible,
• **caractérisé en ce que** le premier potentiel de sortie (OUTs) est transféré à la première barrette à bornes (RK₁) au moyen d'une première prise de pontage (BS₁) à la première barrette à bornes (RK₁) dans un premier plan de pontage,
le système mettant en outre à disposition au niveau d'une seconde colonne de pontage, dans un second plan de pontage, un second potentiel de sortie (GND, IN,) avec fusible qui est différent du premier potentiel de sortie (OUTs)
la tension d'entrée sans fusible (IN) pouvant être raccordée directement à un second porte-fusible électronique (SK₂).

2. Système de distribution selon la revendication 1, **caractérisé en ce que** le système présente en outre au moins une seconde barrette à bornes (RK₂), la seconde barrette à bornes (RK₂) disposant d'au moins une colonne de pontage voisine, le porte-fusible électronique (SK₁) et la seconde barrette à bornes (RK₂) étant 32 directement à proximité sur le rail de montage (TS), le premier potentiel de sortie avec fusible (OUT_{S}) étant transféré à la seconde barrette à bornes (RK₂) au moyen de la première prise de pontage (BS₁) ou d'une seconde prise de pontage (BS₂) à la seconde barrette à bornes (RK₂).

3. Système de distribution selon la revendication 1, **caractérisé en ce que** le système présente en outre au moins une seconde barrette à bornes, le porte-fusible électronique (SK₁) et la seconde barrette à bornes étant disposés directement à proximité sur le rail de montage (TS), le second porte-fusible électronique (SK₂) mettant à disposition au moins le second potentiel de sortie avec fusible, le second potentiel de sortie avec fusible étant transféré à la seconde borne de pontage (SK₁) au moyen d'une seconde prise de pontage (BS₂) à la seconde barrette à bornes.

4. Système de distribution selon une des revendications précédentes, **caractérisé en ce que** le porte-fusible électronique (SK₁) met à disposition un signalement à distance (FM).

5. Système de distribution selon une des revendications précédentes, **caractérisé en ce que** le porte-fusible électronique (SK₁) met à disposition un dispositif d'alarme pour le signalement local des erreurs.

6. Système de distribution selon une des revendications précédentes, **caractérisé en ce que** le porte-fusible électronique (SK₁) présente une largeur de moins de 7 mm, en particulier 6,2 mm.

7. Système de distribution selon une des revendications précédentes, **caractérisé en ce que** le porte-fusible électronique (SK₁) présente une valeur de courant préréglée fixement.

8. Système de distribution selon une des revendications précédentes, **caractérisé en ce que** le porte-fusible électronique (SK₁) limite le courant du potentiel de sortie avec fusible (OUTs) à une valeur préréglée.

9. Système de distribution selon une des revendications précédentes, **caractérisé en ce que** le porte-fusible électronique (SK₁) présente un déclenchement manuel de la fonction fusible.
